# EUROPEAN PATENT APPLICATION

(11) **EP 0 967 845 A1**
(43) Date of publication of application: **29.12.1999**
(21) Application number: 98307666.2
(22) Date of filing: 22.09.1998
(51) Int. Cl.: H05K 3/00, B05C 5/02, B05B 1/04

(54) **Liquid injector**

(30) Priority: 30.04.1998 JP 13761398
(71) Applicant: Tokyo Kakoki Co., Ltd., Edogawa-ku, Tokyo (JP)
(72) Inventor: Niiyama, Kisaburo, c/o Tokyo Kakoki Co., Ltd., Edogawa-ku, Tokyo (JP)
(74) Representative: Jackson, Peter Arthur

(57) **Abstract**

A liquid injector 14 has a slit-shaped injection opening 15 oriented toward a printed wiring board material A transported there so as to cover the width direction D so that a processing liquid B be injected from the slit-shaped injection opening 15 in form of a vertical flat screen with a uniform and strong impact onto the full width of the printed wiring board material A. Thus, the processing liquid B is applied uniformly over the entire surface of the printed wiring board substantially from a right angle and not from largely slanted angles, and it ensures uniform treatment, treatment accuracy to make a circuit having a uniform width and an ideal configuration, injection of a sufficient impact by an expected injection pressure, improvement of the performance of treatment and the processing time.

## Description

This invention relates to a liquid injector used, for example, in a printed wiring board manufacturing process to spray a processing liquid such as developer, etchant or stripping agent.

A printed wiring board, which is representative one of thin plate materials, was manufactured as explained below with reference to Figs. 4A through 7C.

Fig. 4A is a side elevational view of a conventional multi-nozzle system, Fig. 4B is a plan view thereof, Fig. 4C is a side elevational view of a part thereof, and Fig. 4D is a plan view of a part thereof. Fig. 5A is a side elevational view of another conventional multi-nozzle system, Fig. 5B is a front elevational view of a roller therein, and Fig. 5C is a front elevational view of wheels therein.

Fig. 6A is a side elevational view of a central part of another conventional system where nozzles are configured to swing, and Fig. 6B is a side elevational view of another conventional system with a reciprocal conveyor.

Fig. 7A is a plan view of a printed wiring board, Fig. 7B a cross-sectional view of the printed wiring board having formed a circuit, for example, thereon, and Fig. 7C is a cross-sectional view of the printed wiring board having formed an ideal circuit, for example, thereon.

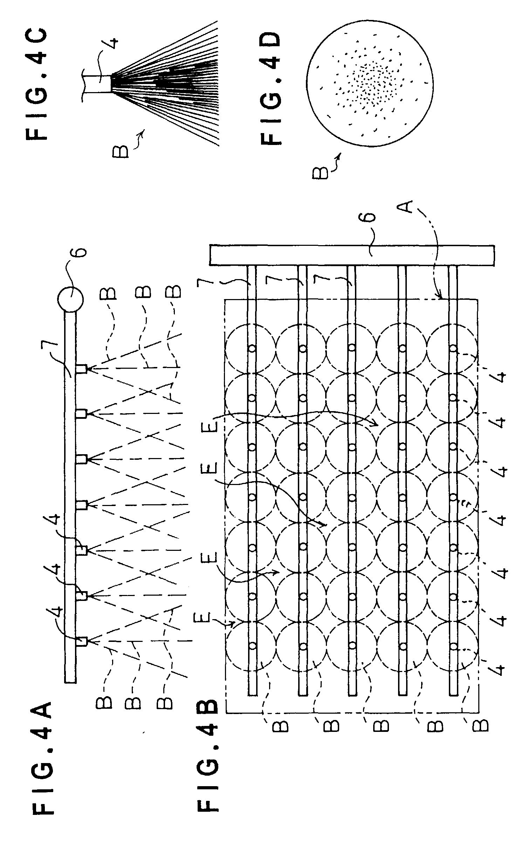

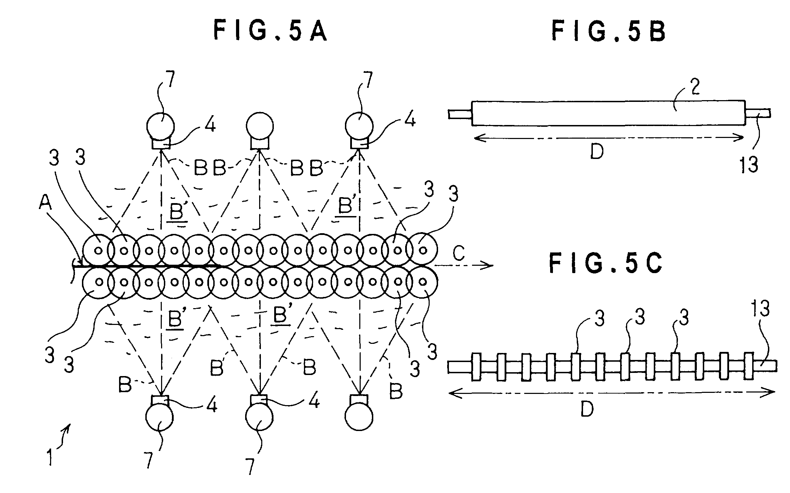

In the conventional systems shown in Figs. 4A to 4D and Figs. 5A to 5C, a number of rollers 2 or wheels 3 of a conveyor 1 are aligned horizontally in a close positional relationship, and are rotated together (in the example of Fig. 5A, a number of wheels 3 are aligned to partly overlap in the front to back (transport) direction) so that the printed wiring board material A be transported sequentially by rollers 2 or wheels 3, maintaining a horizontally lying posture.

While the printed wiring board material A is transported, a processing liquid such as developer, etchant or stripping agent is sprayed onto upper and lower surfaces of the material A from a number of spray nozzles 4 fixed at locations above and below them.

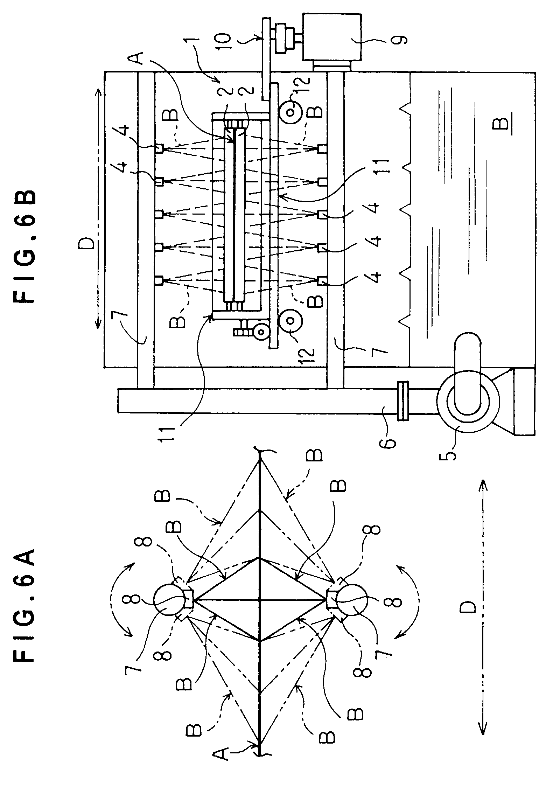

The spray nozzle 4 is of a typical type having a mechanism (not shown) therein for spraying and spreading an atomized liquid. The processing liquid B pumped and sent from a pump 5 (see Fig. 6B) via a main tube 6 and a plurality of spray pipes 7 hits a sprayer plate, or the like, of the spray/spreading mechanism and then exits and spreads from a small bore.

A number of spray nozzles 4 are aligned in arrays in the front-to-back (transport) direction C along the transporting path of the conveyor 1, arrays in the right-to-left (width) direction D across the transporting path and in some vertical levels. That is, a number of spray nozzles 4 are provided in predetermined intervals in the transport and width directions over a wide area within the processing chamber surrounded by the transport direction C of the conveyor 1 and the width direction D across the transporting direction C.

The spray nozzles 4 shown in Figs. 4A to 4B and Figs. 5A to 5C configured as explained above have been used most widely.

The example shown in Fig. 6A is an improvement of the spray nozzles shown in Figs. 4A through 5C. The example shown here uses swinging nozzles 8. That is, spray pipes 7 extending in parallel along the transporting direction C are configured to continuously swing in the width direction D about their axes. As a result, swinging nozzles 8 formed on spray pipes 7 at constant intervals reciprocally swing in the width direction D.

In the other respects related to the conveyor 1, printed wiring board material A, processing liquid B, and so on, the swinging nozzles 8 shown in Fig. 6B are the same as those of Figs. 4A through 5C.

The example shown in Fig. 6B is an improvement of the spray nozzles 4 shown in Figs. 4A through 5C. The example shown here uses a conveyor 1 which is movable reciprocally in the fight-and-left width direction. In the examples Figs. 4A to 4D, 5A to 5C and 6A, the conveyor 1 is moved only in the transporting direction C by a number of wheels 3 (or rollers 2) extending in the width direction D in a close parallel alignment.

In contrast, in the example shown in Fig. 6B, reciprocal shaking movement in the width direction is added to the movement of the conveyor 1. That is, while a number of spray nozzles 4 above and under the conveyor 1 are stationary (unlike the example of Fig. 6A), the conveyor 1 transporting the printed wiring board material A swings in the width direction.

Numeral 9 denotes an eccentric motor in an oscillation mechanism for the reciprocal movement, 10 denotes a motor power transfer means having a gear, and 11 denotes a holder. The holder 11 is connected to the power transfer means 10, supports the conveyor 1, and can reciprocally move on pulleys in the width direction D. As a result, the conveyor 1 is shaken in the width direction D.

In the other respects regarding printed wiring board material A, spray nozzles 4, processing liquid B, etc., the example shown in Fig. 6B is the same as those of Figs. 4A through 5C.

The prior art examples shown above involved various problems. First, in the prior art examples shown in Figs. 4A through 5C, it was difficult to accomplish uniform treatment such as development, etching and separation, and a low treatment accuracy was pointed out.

More specifically, in these prior art examples, a developer, etchant, stripping agent or other processing liquid B was sprayed from spray nozzles 4 located stationary above and under the printed wiring board material A onto it while it is transported.

In the process, as shown in Figs. 4C and 4D, the processing liquid B becomes dense in centers of spray nozzles 4 but dilute in the outer circumference thereof, and it is sprayed to expand in a circular conic configuration. That is, the processing liquid B sprayed out of each spray nozzle and spread in a circular conic configuration is not even in density through its covering area, and makes a difference in injection pressure and sprayed quantity between the central portion and the outer circumferential portion.

Moreover, with regard to the relationship among adjacent spray nozzles 4, there often remain a number of regions where the processing liquid B sprayed out from the spray nozzles 4 does not reach and cover. This was another aspect of non-uniformity of the processing liquid B sprayed and spread from the spray nozzles 4.

The difference in density, injection pressure and sprayed quantity of the processing liquid B, and also non-applied regions, inevitably caused unevenness in development, etching, stripping or other processing of the printed wiring board material A to which the processing liquid B be sprayed.

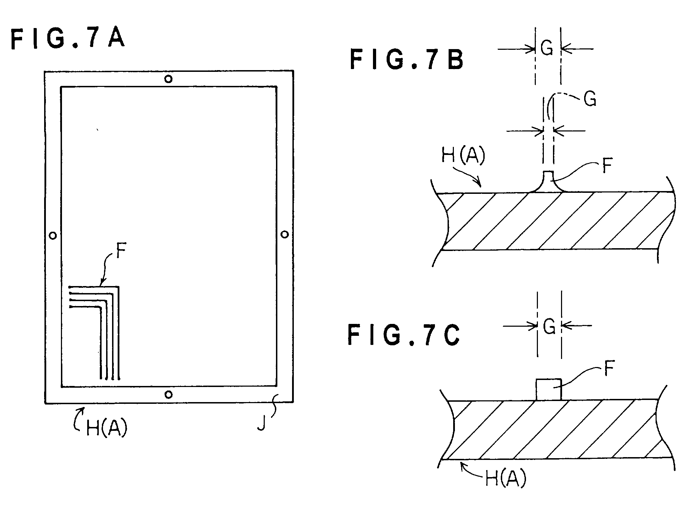

For example, if etching progresses unevenly, a circuit F (see Figs. 7A through 7C) made on the printed wiring board material A fails to have a proper width G. For example, if the width G should be 50 µm, portions of 30 µm or 70 µm, for example, appear on the same printed wiring board H. In this case, if it is tried to obtain the circuit width G of 50 µm, it possibly results in disappearance of portions of 30 µm.

Thus, in these prior art examples, development, etching, stripping or other treatment was liable to be excessive or insufficient and to be uneven, which means a processing inaccuracy. As a result, the circuit F made by the treatment was not constant in width, which was a serious problem for the printed wiring board H for which higher density, miniaturization and high-accuracy of the circuit F are demanded continuously.

Second, in the prior art examples shown in Figs. 4A through 5C, the shape of the circuit F made on the printed wiring board H did not exhibit the ideal shape shown in Fig. 7C but represented a frustum cross-sectional configuration as shown in Fig. 7B.

More specifically, in these prior art examples, the processing liquid B is sprayed from each spray nozzle 4 and spread in a circular conic configuration as shown in Fig. 4A and Fig. 4C. Therefore, the processing liquid B is sprayed onto the printed wiring board material A from various spray angles in all directions throughout 360° other than substantially right angles.

That is, most of the processing liquid B is applied from lateral directions with various large spray angles in all directions rather than vertical directions from just above or just below the printed wiring board material A. As a result, the shape of the circuit F formed on the printed wiring board material A becomes a mountain-like shape in its cross-sectional new.

In the case where the circuit width G should be 50 µm, for example, when an etchant is sprayed as the processing liquid B for etching, side etching of the circuit F likely progresses , and results in making the circuit width G on the top surface as extremely thin as 30 µm or 20 µm.

In this manner, these prior art examples were configured to spray the processing liquid B from various large spray angles from all lateral directions during development, etching, stripping or other treatment. Therefore, the shape of the circuit F often became a mountain-like frustum configuration in its cross-sectional view, which is far from the ideal shape with a substantially square or rectangular cross section as shown in Fig. 7C.

It resulted in changes in electric current flowing in the circuit F and generation of heat during practical use of the printed wiring board. Also these were serious problems for the printed wiring boards H which should be progressed in integration density and miniaturization of the circuit F.

Thirdly, in The prior art examples shown in Figs. 4A through 5C, the pressure of the processing liquid B was low, and an expected injection pressure was not obtained. Therefore, the impact to the printed wiring board material A was insufficient, and problems on the processing performance, processing speed, and so on, during development, etching, stripping or other treatment were pointed out.

That is, since the spray nozzles 4 used in the prior art examples are so configured that the processing liquid D from the pump 5 first hits the sprayer plate or other spreading mechanism and then exits from a circular small bore while spreading its diameter in a circular conic configuration. Since the processing liquid B sprayed from spray nozzles 4 spread its diameter, its pressure was low, and the impact was weak.

Even when a pump 5 with a higher pressure was used, it merely resulted in enlarging the circular conic spray angle, and it was difficult to obtain an expected injection pressure. Thus, the problem of an insufficient impact still remained. Although a pump 5 with a very high pressure was used, its energy was consumed in increasing the spray angle, and could not increase the injection pressure of the processing liquid B. Therefore, this approach could not overcome the problem, entangled with the above-mentioned problems of the difference in density of the processing liquid B as well.

In this manner, in these prior art examples, the injection pressure of the processing liquid B was low, and the impact to printed wiring board materials A was insufficient during development, etching, stripping or other processing. Therefore, low processing performance, long processing time and bad productivity were pointed out.

Fourth, in the prior art examples shown in Figs. 4A through 5C, the processing liquid B sprayed and spread from each spray nozzle 4 in a circular conic configuration was splashed by wheels 3 or rollers 2 of the conveyor 1, and the splashed processing liquid B' caused inaccuracy of treatment pointed above as the first problem and low treatment performance pointed above as the third problem.

More specifically, the processing liquid B sprayed from each of a number of spray nozzles 4 arranged in upper and lower locations in the processing chamber spread its diameter in a circular conic configuration, and a large part thereof failed to directly reach the printed wiring board material A but hit and splashed from rollers 2 or wheels 3 of the conveyor 1. Particles of the splashed processing liquid B' hit each other and dropped onto the printed wiring board material A, made a puddle of high-concentrated processing liquid B in a central portion of printed wiring board material A, and the processing liquid B in the puddle in the central portion could not be renewed.

In this manner, the prior art examples likely made on the printed wiring board material A portions directly exposed to the processing liquid B and portions not directly exposed thereto, and likely made a puddle of the processing liquid B in the center of the printed wiring board material A.

Therefore, the first pointed-out problem, namely, excessive or insufficient development, etching, stripping or other treatment, and uneven treatment, were liable to occur.

Additionally, it resulted in the third pointed-out problems, namely, insufficient impact of the processing liquid B to the printed wiring board material A, low treatment performance, longer processing time and bad productivity.

Fifth, the prior art examples shown in Figs. 4A through 5C employed various trial improvements in locations of spray nozzles 4 to overcome the first to fourth problems, but failed to fundamentally overcome these problems.

There were also proposed the structure using swinging nozzles 8 as shown in Fig. 6A and the structure configured to shake the conveyor 1 in the width direction. These prior art structures were employed to prevent the first pointed-out problems, namely, removal of excessively or insufficiently processed portions, uneven treatment, and so on, and attained a certain effect regarding the first pointed-out problems. However, second, third and fourth issues still remained.

That is, also in the prior art examples shown in Figs. 6A and 6B, the processing liquid B was sprayed from spray nozzles 4, expanding its diameter, and the circuit F was shaped into a mountain-like frustum configuration in its cross section as shown in Fig. 7B. Expansion of the diameter of the sprayed processing liquid B was increased by swinging movements or reciprocal movements of the spray nozzles 4, and the shape of the circuit F became remoter from the ideal shape shown in Fig. 7C.

Moreover, also in the prior art examples shown in Figs. 6A and 6B, since the processing liquid B expanded its diameter in a circular conic configuration after exiting from spray nozzles 4, its pressure was low, and the impact to the printed wiring board material A was insufficient. Here again, the problems of low treatment performance, longer processing time and insufficient productivity were pointed out.

Furthermore, the processing liquid B hit and splashed from rollers 2 or wheels 3 of the conveyor, and likely made on the printed wiring board material A portions not directly exposed thereto while making a puddle of the processing liquid. Also from these viewpoints, there were pointed out the problems of excessive or insufficient processing liquid, unevenness, inaccurate treatment, insufficient impact, low treatment performance, longer processing time and insufficient productivity.

In the prior art examples shown in Figs. 6A and 6B using the swinging nozzles 8 or the reciprocal conveyor 1, there was the need for the oscillation mechanism including the motor 9 and the driving power transmitter 10, or a swinging mechanism. It inevitably invited additional problems, namely, complex entire structure, much larger expenses for the system, and troublesome maintenance of the mechanism.

It is therefore an object of the invention to provide a liquid injector readily realizing even treatment, accuracy of treatment, substantially straight angle of a processing liquid, sufficient impact of the processing liquid by an expected injection pressure onto objects to be treated, high treatment performance, shorter processing time.

According to the invention, there is provided a liquid projector for injecting a processing liquid onto a thin plate material transported successively, comprising a slit-shaped injection opening configured to apply the processing liquid over the full width of the thin plate material.

The slit-shaped injection opening is preferably located to face against the thin plate material transported sequentially and configured to release a stream of the processing liquid in form of a vertical screen which is substantially even in thickness and as wide as the full width of the thin plate material.

The slit-shaped injection opening is preferably adjustable in width to regulate the pressure and quantity of the processing liquid injected therefrom.

The slit-shaped injection opening may be disposed to direct the processing liquid injected therefrom from a direction normal to the thin plate material so that the thin plate material be exposed to the screen-like processing liquid from the normal direction.

The slit-shaped injection opening may be disposed to direct the processing liquid injected therefrom slightly aslant from a normal direction to the thin plate material so that the thin plate material be exposed to the screen-like processing liquid from the direction slightly aslant from the normal direction.

The slit-shaped injection opening is preferably disposed to face against a gap between rollers or wheels of a conveyor transporting the thin plate material so that the processing liquid be applied directly onto the thin film material without hitting the rollers or wheels.

The liquid injector may be used in a process for manufacturing a printed wiring board to inject a developer, etchant, stripping agent or wash water as the processing liquid onto printed wiring board materials as the thin plate materials.

In the accompanying drawings:

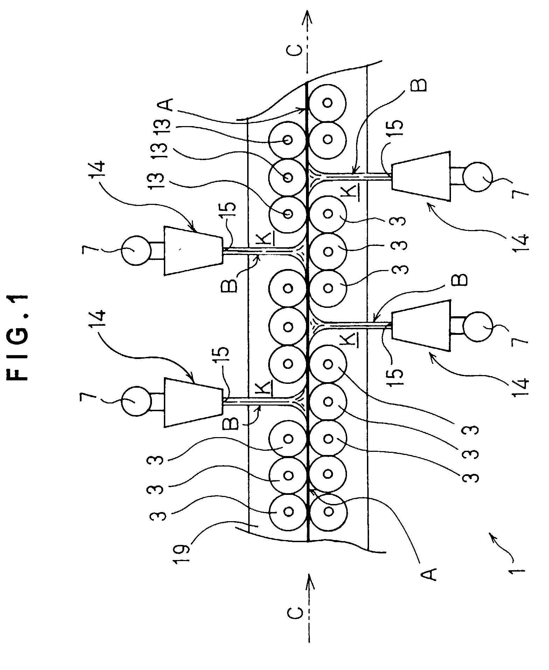

Fig. 1 is a side elevational view of a liquid injector taken as a first embodiment of the present invention;

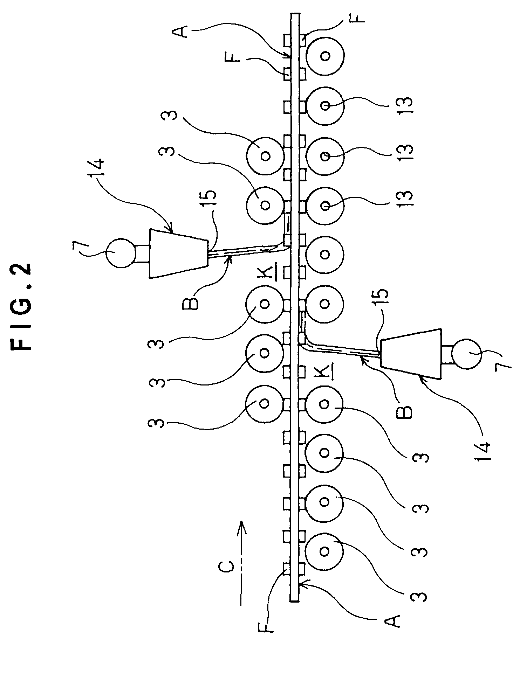

Fig. 2 is a side elevational view of a liquid injector taken as a second embodiment of the invention;

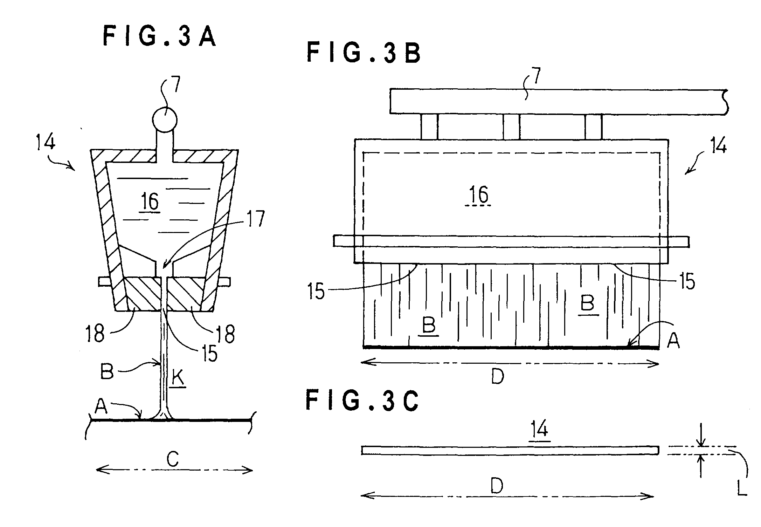

Fig. 3A is a cross-sectional view of a central part of the same embodiment;
Fig. 3B is a front elevational view of the central part of the same embodiment;
Fig. 3C is a bottom view of the central part of the same embodiment;
Fig. 4A is a side elevational view of a prior art example;
Fig. 4B is a plan view of the same prior art example;
Fig. 4C is a side elevational view of a central part of the same prior art example;
Fig. 4D is a plan view of the central part of the same prior art example;
Fig. 5A is a side elevational view of another prior art example;
Fig. 5B is a front elevational view of rollers in the same prior art example;
Fig. 5C is a front elevational view of wheels in the same prior art example;
Fig. 6A is a side elevational view of a central part of another conventional example using swinging nozzles;
Fig. 6B is a side elevational view of another prior art examples using a swinging conveyor;
Fig. 7A is a plan view of a printed wiring board;
Fig. 7B is a cross-sectional view of a circuit, or the like, in a prior art example; and
Fig. 7C is a cross-sectional view of an ideal circuit, or the like.

Explained below are some embodiments of the invention with reference to the drawings. Figs. 1 through 3C show these embodiments of the invention.

Liquid injectors are used in various processes for manufacturing, re-treatment or other treatment of thin plate materials. Explanation is made here as using liquid injectors in a manufacturing process of a printed wiring board H as the thin plate material. A printed wiring board H to be fabricated is explained with reference to Figs. 7A through 7C.

There are various printed wiring boards H for use in office-automation devices, portable telephones, computers, calculators, and so on, and they are manufactured in various manners. Printed wiring boards H have been made more and more compact, light, thin, flexible and multi-layered, and high integration, miniaturization and high accuracy of circuits F are under ever-lasting progress.

Printed wiring boards H are manufactured, for example, by sequentially sending each printed wiring board material A trough various steps, such as stacking of layers, abrasion, cutting, application of an etching resist, drying, bonding, exposure, development etching, removal of the etching resist from selective portions for circuits F.

In greater detail, after copper foils are first bonded to opposite surfaces of an insulating base material of polyimide, for example, by heat press, the semi product is rinsed and polished. The multi-layered printed wiring board material A having copper foils on opposite surfaces by the pretreatment is cut into shorter ones of a work size. Then, after boring for making a number of trough holes, rinsing and polishing, it is plated. As a result, also the inner wall of each trough hole is metalized to electrically connect the circuit F on the front surface to the circuit F on the bottom surface.

Alternatively, the printed wiring board material A may be a multi-layered plate with a copper foil only on one surface. In this case, also a photo-sensitive resistive, explained later, is applied only on one surface. Needless to say, the present invention is applicable for a printed wiring board material A of this type.

Through holes made in a single printed wiring board material A (printed wiring board H) are micro-sized holes as many as hundreds or thousands.

After that, the printed wiring board material A again undertakes rinsing, polishing and drying. Then, an etching resist, that is, an anti-alkali or anti-acid protective photo-sensitive resist is applied onto the printed wiring board material A and dried.

Then, a negative film of the circuit F is applied onto each surface of the printed wiring board material A for making the circuit F, and it is exposed to light. As a result, the photo-sensitive resist is cured by exposure in portions of the circuit F, and the dissolved and removed from the remainder portions by injecting a developer as the processing liquid B.

Thereafter, the printed wiring board A is rinsed and dried, and next moved to an etching machine to inject an etchant as the processing liquid B to dissolve and remove selective portions of the copper foil, where the photo-sensitive resist has been dissolved and removed, other than the protected part of the copper foil in the portions of the circuit F.

Thereafter, the remainder part of the photo-sensitive resist on the portions of the circuit F is dissolved and removed by injecting a stripping agent as the processing liquid B, and then washed and dried. As a result, the printed wiring board H having formed the circuit F thereon is obtained.

The printed wiring board H, thus obtained, is as large as approximately 550mm long and 550mm wide, 500mm long and 500mm wide, or 500mm long and 300mm wide, for example. The thickness of the insulating substrate is approximately 0.06mm, for example, and the circuit F of the copper foil is as thin as approximately 0.018mm, for example. Even when the printed wiring board H is made of four layers, for example, the entire thickness is going thinner and thinner from 1.0mm to 0.8mm further to 0.4mm.

Also the width of the circuit G is becoming thinner and thinner from 70µm to 50µm further to 40µm. The peripheral edge of the printed wiring board H surrounding the circuit F is a lug J which is 10mm wide approximately.

A protective film is made on the printed wiring board H made by the above-explained process to protect the circuit F as a secondary treatment in the manufacturing process.

In the manufacturing process of the printed wiring board H, such as development process, etching process, stripping process, etc., chemical liquids like developer, etchant, stripping agent, etc. as processing liquids B are injected to perform chemical treatment such as development, etching or stripping while the printed wiring board material A is transported.

That is, in each treatment chamber for each process, the printed wiring board material A is transported in a horizontal posture by a conveyor 1. In the conveyor 1, a number of rollers 2 or wheels 3 are aligned in the direction along the transport direction C so that rods 13 extend horizontally in parallel with the width direction D. Each rod 13 used in the examples shown in Figs. 1 and 2 has wheels 3 in predetermined intervals (see Fig. 5C); however, the rod 13 of the type of a straight roller 2 (see Fig. 5B) may be used alternatively.

In the examples shown in Figs. 1 and 2, wheels 3 are provided in upper and lower levels to sandwich the printed wiring boards A so that the lower wheels 3 are driven to transport them whereas the upper wheels 3 are freely rotated to press them.

In the example of Fig. 1, upper and lower wheels 3 are closely aligned along the transport direction except for gaps K of a size corresponding to a single wheel 3 (in the illustrated example, they are aligned closely to partly overlap in the lengthwise direction of the rods 13).

In the example of Fig. 2, however, upper and lower wheels 3 are aligned in intervals each corresponding to one third of one wheel 3 except for the gaps K interposed along the transport path.

Next explained are liquid injectors 14 according to the invention with reference to Figs. 1 through Fig. 3C. The liquid injectors 14 are used in manufacturing processes of printed wiring boards H in the illustrated examples. The thin plate material shown here is a printed wiring board material A on which the circuit F will be formed, and the processing liquid B is a developer, etchant or stripping agent, for example.

The liquid injectors 14 includes a slit-shaped injection opening 15 for injecting a processing liquid B toward a thin plate material like the printed wiring board material A transported by the conveyor 1, and the slit-shaped injection opening 15 is configured to inject the processing liquid B to the full width of the thin plate material like the printed wiring board A.

That is, the slit-shaped injection opening 15 of the liquid injector 14 extends along the width direction D across the transport direction C and has a length approximately equal to the width of the conveyor 1. Alternatively, the slit-shaped injection opening 15 may be diagonal relative to the width direction.

The processing liquid B is supplied from a spray pipe 7 to fill a liquid reservoir 16, and it is injected from the slit-shaped injection opening 15 toward the printed wiring board material A as shown in Fig. 3B. Thus, the processing liquid B makes a substantially flat screen of liquid wide enough to cover the entire width of the printed wiring board A. The screen-like processing liquid B does not expand or disperse, but runs straight.

The slit-shaped injection opening of the liquid injector 14 is adjustable in width L as shown in Fig. 3C to regulate the pressure and flow amount of the processing liquid B.

The liquid reservoir 16 has formed at one end thereof a straight slit-shaped gap 17 of a predetermined width extending along the width direction D. A pair of adjusters 18 movable to and away with each other are provided adjacent to the slit-shaped gap 17 to define the slit-shaped opening 15 adjustable in width L. Thus, the pressure or flow amount of the processing liquid B injected therethrough can be regulated.

The slit-shaped injection opening 15 of the liquid injector 14 is oriented to each gap K between rollers 2 or wheels 3 of the conveyor 1 so that the processing liquid B be injected directly straight to the surface of the printed wiring board material A transported sequentially without hitting the rollers 2 or wheels 3.

In the example shown in Fig. 1, two gaps K each corresponding to the diameter of each wheel 3 are provided between wheels 3 in each of upper and lower close alignments of wheels 3. In the example shown in Fig. 2, a gap K corresponding to the diameter of one wheel 3 is provided in each of upper and lower spaced alignments of wheels 3.

The liquid injector 14 is located above or below the gap K so as to orient the slit-shaped injection opening 15 toward the gap K. Therefore, the processing liquid B injected from the slit-shaped opening 15 reaches the printed wiring board material A directly straight through the gap K without hitting the wheels 3.

In the example shown in Fig. 2, the gaps K are intentionally provided. However, the gaps between the spaced wheels 3 may be used as gaps K so as to orient the slit-shaped injection opening 15 of the liquid injector 14 thereto.

In the example shown in Fig. 1, the slit-shaped injection opening 15 of the liquid injector 14 is so disposed that its injection angle be normal to the printed wiring board material A or other thin plate material transported by the conveyor.

That is, the slit-shaped injection opening 15 is set so that The processing liquid B in form of a vertically straight screen be injected onto the printed wiring board material A transported in a horizontally lying posture.

In contrast, in the example shown in Fig. 2, slit-shaped injection openings 15 of the upper and lower liquid injectors 14 are so disposed that their injection angles be slightly aslant from right angles relative to the printed wiring board material A or other thin plate material transported successively. That is, each slit-shaped injection opening 15 is set so that the processing liquid B in form of a screen be injected onto the printed wiring board material A or other thin plate material from a direction slightly aslant from a right angle.

The slanted injection angle is as small as 5 degrees, for example, and may be any from one to 2 degrees, minimum, to 10 degrees, maximum, approximately.

In the illustrated example, both slit-shaped injection openings 15 are slanted toward the downstream side in the transport direction C so that the exiting angle from the slit-shaped injection opening 15 be an obtuse angle on the upstream side and an acute angle on the down stream side, and the incident angle to the printed wiring board material A be an acute angle on the upstream side and an obtuse angle on the downstream side. The injection angle, however, may be aslant oppositely toward the upstream side in the transport direction C. In this case, the exiting angle from the slit-shaped injection opening 15 becomes an acute angle on the down stream side and an obtuse angle on the downstream side, and the incident angle to the printed wiring board material A becomes an obtuse angle on the upstream side and an acute angle on the downstream side.

The liquid injectors 14 are used in a manufacturing process of the printed wiring board H to inject a developer, etchant or stripping agent as the processing liquid B. The processing liquid B supplied from the liquid injector 14, however, may be any such as rinsing water, other than the above-mentioned chemical liquids for chemical treatment. That is, the liquid injector 14 and the slit-shaped injection opening 15 can be used in a rinsing process to supply rinsing water. In Fig. 1, reference numeral 19 denotes a frame of the conveyor 1.

In the illustrated example, the printed wiring board material A or other thin plate material is transported in a horizontally lying posture, and the slit-shaped injection opening 15 is disposed to extend over the full width of the printed wiring board material A. However, it is also possible to transport the printed wiring board material A or other thin plate material in a posture aslant in the width direction and to dispose the slit-shaped injection opening 15 aslant toward the material A so as to cover its full width.

The liquid injector 14 having the above-explained stricture is used as explained below. As shown in Figs. 1 through 3C, the liquid injectors 14 are used in a manufacturing process of the printed wiring board H, for example, to inject a processing liquid B such as developer, etchant or stripping agent against printed wiring board materials A transported one by one by rollers 2 or wheels 3 in a horizontally lying posture.

Each liquid injector 14 includes a single continuous slit-shaped injection opening 15 which is disposed to extend in the width direction D across the transport direction C to cover the full length of the printed wiring board material A.

Therefore, the processing liquid B pumped and sent from the pump 5 through the main pipe 6, spray pipe 7, etc. is injected straight in form of a vertical flat screen directly onto the printed wiring board material A over the full width thereof, with an even thickness and a sufficient impact maintaining its expected injection pressure, without spreading widely.

Thus, the liquid injector 14 exhibits the following features.

First, in the illustrated example where the liquid injectors 14 are used in a manufacturing process of the printed wiring board H, the processing liquid B such as developer, etchant or stripping agent is injected from each slit-shaped injection opening 15 onto printed wiring board materials A transported there sequentially to perform treatment thereof such as development, etching or stripping.

The processing liquid B injected from the opening 15 forms a straight screen of liquid wide enough to cover the full width of the printed wiring board material A.

In this manner, the processing liquid is supplied to the printed wiring board material A in form of a straight screen of liquid with an even density throughout its entire width.

That is, unlike the prior art examples shown in Figs. 4A through 4D where the processing liquid B was sprayed in form of a conically expanded configuration, the invention reliably prevents uneven supply of the processing liquid B onto the printed wiring board material A, such as uneven density, difference in pressure and quantity of the processing liquid B, or making regions E where the processing liquid B fails to reach.

Therefore, the invention ensures uniform treatment of the entire area of the printed wiring board material A by development, etching or stripping without causing excessive or insufficient treatment. As a result, where the circuit F with a circuit width of 50µm, for example, is required on the printed wiring board material A (printed wiring board H), the circuit F having the circuit width G substantially as desired throughout its entirety can be made.

Second, in the illustrated examples, the liquid injector 14 is used in a manufacturing process of the printed wiring board H, and configured to the inject the processing liquid B from the slit-shaped injection opening 15 onto the printed wiring board material A transported successively. The slit-shaped injection opening 15 is oriented toward the printed wiring board material A.

That is, in the example shown in Fig. 1, the processing liquid B is supplied to the printed wiring board material A with a right angle from just above or just below it. In the example shown in Fig. 2, the processing liquid B is supplied to the printed wiring board material A substantially with a right angle from just above or below it. In other words, the processing liquid is injected with a right injection angle in the example shown in Fig. 1 and with an injection angle slightly aslant from the right angle by approximately 5 degrees in the transport direction in the example shown in Fig. 2.

As a result, the processing liquid B is supplied onto the printed wiring board material A, particularly to its surface for making the circuit F, in a manner minimizing adverse affections by angles, and development, etching, stripping or any other treatment is performed.

That is, the processing liquid B is not supplied from lateral sides with various spray angles over all directions of 360 degrees like the prior art examples shown in Figs. 4A through 6B configured to inject the processing liquid B in a conically spread configuration.

As a result, the circuit F formed on the printed wiring board material A (printed wiring board H) is nearer to the ideal square or rectangular configuration in its cross section as shown in Fig. 7C. That is, it is alleviated that it becomes a mountain-like frustum configuration like that by the prior art example shown in Fig. 7B due to side etching, for example.

Third, in the illustrated example, the liquid injector 14 is used in a manufacturing process of the printed wiring board H, and the processing liquid B is supplied from the slit-shaped injection opening 15 in form of a substantially flat vertical screen of liquid which is straight without spreading widely.

That is, it is different from the prior art examples shown in Figs. 4A through 6B configured to strike the processing liquid B from the pump 5 against a sprayer plate or other spreading mechanism to make a conically expanded flow of the processing liquid.

The liquid injector 14 according to the invention releases the processing liquid B directly straight from the slit-shaped injection opening 15 not through any spreading mechanism. Therefore, the pressure pump 5 directly affects the injection pressure of the processing liquid B, and the processing liquid B is readily supplied onto the printed wiring board A with a strong impact determined by the expected injection pressure.

Therefore, the expected injection pressure and a strong impact can be obtained easily without using a higher-pressure pump 5.

In this manner, the liquid injector 14 injects the processing liquid B such as developer, etchant or stripping agent from the slit-shaped injection opening 15 with a strong impact under an expected injection pressure onto the printed wiring board material A, and it is remarkably excellent in treatment performance by development, etching or stripping.

In the example shown in Fig. 3A, the width L of the slit-shaped injection opening 15 is adjustable by changing the distance between the adjusters 18. Therefore, optimum injection pressure and impact can be selected on the part of the liquid injector 14 by changing the pressure and flow amount of the processing liquid B.

Fourth, in the illustrated examples, the liquid injector 14 is used in a manufacturing process of the printed wiring board H, and the processing liquid B is injected directly in form of a vertical flat screen from the slit-shaped injection opening 15.

That is, the processing liquid is not supplied in a conically spread configuration from each of spray nozzles arranged in upper and lower levels in a processing chamber as in the prior art examples shown in Figs. 4A through 6B.

The liquid injector 14 replacing prior art spray nozzles 4 need not be placed over the entire area of processing chamber for development, etching or stripping, but it is sufficient to set one or two liquid injectors 14 at upper and lower locations, respectively, along the width direction D.

Therefore, it is easy for the liquid injector 14 to be located and inject the processing liquid B, avoiding the rollers 2 or wheels 3 of the conveyor 1 transporting the printed wiring board material A.

For example, one or two gaps K can be made between wheels 3 of the conveyor 1 as shown in Figs. 1 and 2, and the liquid injector 14 can be easily located in alignment with each gap K to inject the processing liquid B from the slit-shaped injection opening 15.

The processing liquid B injected in this manner passes through the gap K without hitting wheels 3, and directly reaches the printed wiring board material A.

Therefore, the invention can prevent the defects of the prior art examples that the sprayed processing liquid B hits and splashes from wheels 3 (see the processing liquid B' in Fig. 5A) and that the splashed liquid B' falls and makes a puddle of on a central portion of the printed wiring board material A and disturbs renewal of the processing liquid.

As a result, also from this viewpoint, development, etching, stripping or other treatment by a developer, etchant, stripping agent or other processing liquid B can be effected uniformly with a strong impact by the expected injection pressure.

Consequently, explanation is made below on the case where the slit-shaped injection opening 15 of the liquid injector 14 is disposed to slightly incline its injection angle from a right angle to the upstream or downstream side (to the downstream side in the illustrated example) with respect to the printed wiring board material A held in a horizontally lying posture.

In this case, the screen-like processing liquid B reaches the material A with an angle aslant from a right angle. Therefore, after reaching the printed wiring board material A, the processing liquid B flows on the surface thereof to make the circuit F thereon toward the downstream or upstream direction along the transport direction C, and then enters to the liquid tank.

When the slit-shaped injection opening 15 inclines toward the downstream side along the transport direction C as shown in Fig. 2, a regular, uniform flow of the processing liquid D toward the downstream direction is formed on the printed wiring board material A. In contrast, when the slit-shaped injection opening 15 inclines toward the upstream side along the transport direction C, a regular, uniform flow of the processing liquid B toward the upstream direction is made on the printed wiring board material A.

In this manner, when the slit-shaped injection opening 15 is slightly aslant in the transport direction, the injected processing liquid B flows regularly, uniformly on the printed wiring board material A toward the upstream or downstream direction. Therefore, development, etching, stripping or other treatment is made uniformly by more reliably removing puddles.

When the slit-shaped injection opening is disposed at a right angle relative to the printed wiring board material in a horizontally lying posture as shown in Fig. 1, such a regular flow is not made, and mixture of flows in the upstream direction and in the downstream direction are made.

Fifth, the liquid injector 14 is configured and disposed to orient the slit-shaped injection opening 15 to cover the entire width of the printed wiring board A transported by the conveyor.

That is, it is not necessary to arrange a number of spray nozzles 4 above and below the printed wiring board material A brought there over the entire area thereof as in the prior art examples shown in Figs. 4A through 6B, and it is sufficient to provide one or more liquid injectors 14 in one or more locations. Moreover, swinging nozzles 8 or a mechanism for shaking the conveyor 1 need not be used, and it is sufficient to set the liquid injector 14 stationary.

In this fashion, the liquid injector 14 has a simple structure and readily attains the first to fourth effects.

As explained above, the liquid injector according to the invention realizes the following effects by employing the slit-shaped injection and locating it to cover the width and to inject a processing liquid in form of a screen.

First, uniform treatment and processing accuracy are promised. That is, since the processing liquid is supplied in form of a straight screen onto a printed wiring board material or other thin plate material transported there from the slit-shaped injection opening oriented thereto to cover its entire width, uniform treatment is ensured, and processing accuracy is increased.

Second, the processing liquid is supplied not to largely increase the injection angle. That is, the processing liquid is supplied in form of a straight screen onto the printed wiring board material or other thin plate material from the slit-shaped injection opening disposed to cover its full width. Therefore, when the liquid injector is used in a manufacturing process of a printed wiring board, for example, the processing liquid such as developer, etchant, stripping agent, rinsing water, etc. is supplied from just above or just below of the material to be treated, by an injection angle substantially normal thereto. As a result, development, etching, stripping, rinsing, or other treatment can be performed under less adverse affections by angles.

Third, the liquid injector promises injection of the processing liquid with a strong impact by the expected injection pressure, and is excellent in processing performance and processing time.

According to the liquid injector, the pumping pressure directly reflects the injection pressure of the processing liquid, and the expected injection pressure can be obtained easily to ensure injection of the processing liquid with a strong impact onto the printed wiring board material or other thin plate material. That is, the problem of insufficient impact in the prior art examples is removed, and an expected injection pressure and a strong impact can be obtained easily without using a special pump for a higher pressure. According to the invention, a sufficient injection pressure and a sufficient impact have been obtained by a pumping pressure corresponding to 1/20 of the typical conventional pumping pressure, for example. Additionally, the etching time has been reduced by 50% as compared with prior art devices.

Fourth, since the processing liquid is injected directly, the invention improves the processing accuracy, processing performance and processing time.

According to the invention, since the processing liquid may be injected collectively along the width direction, it is possible and easy to locate the liquid injector and to supply the processing liquid, avoiding wheels or rollers of the conveyor. For example, it is possible to make gaps between rollers or wheels of the conveyor and to locate the liquid injector and injection therefrom in alignment with each gap.

As a result, the processing liquid is supplied directly onto the printed wiring board material without hitting rollers or wheels.

Additionally, here again, the liquid injector promises uniform treatment and a high treatment accuracy as indicated above as the first effects, and realizes injection of a high impact by the expected injection pressure, thus improving the performance of treatment and the processing time.

Fifth, these effects are realized easily. That is, the liquid injector has a simple structure where the slit-shaped injection opening is located in confrontation with a printed wiring board material or other thin plate material transported thereto so as to cover the width direction. Therefore, it contributes to decreasing the investment for installment, causing no additional labor for its maintenance, and easily realizes the first to fourth effects mentioned above.

## Claims

1. A liquid injector for supplying a processing liquid onto a thin plate material transported sequentially, comprising:
a slit-shaped injection opening configured to inject the processing liquid over the full width of said thin plate material.

2. The liquid injector according to claim 1 wherein said slit-shaped injection opening is located in confrontation with said thin plate material transported thereto to cover its width direction and not the transport direction so that the processing liquid pumped out from a pump through a pipe be injected in form of a vertical flat screen straight from said slit-shaped injection opening toward the full width of the thin plate material without spreading the processing liquid.

3. The liquid injector according to claim 2 wherein said slit-shaped injection opening in adjustable in width in the transport direction to appropriately determine the pressure and flow amount of the processing liquid injected therefrom.

4. The liquid injector according to claim 2 wherein said slit-shaped injection opening is disposed so that the injection angle be normal to the thin plate material and the processing liquid be injected in form of a screen making a right angle.

5. The liquid injector according to claim 2 wherein said slit-shaped injection opening is disposed so that the injection angle be slightly aslant from a right angle relative to the thin plate material and the processing liquid be injected in form of a screen slightly aslant from the right angle onto the thin plate material.

6. The liquid injector according to claim 2 wherein said slit-shaped injection opening is aligned with a gap between rollers or wheels of a conveyor for transporting the thin plate material so that the processing liquid be directly applied to the thin plate material without hitting the rollers or wheels.

7. The liquid injector according to claim 2 wherein said liquid injector is used in a manufacturing process of a printed wiring board, said thin plate material being a printed wiring board material having a surface for making a circuit thereon, said processing liquid being one of developer, etchant, stripping agent and rinsing water.
